# EUROPEAN PATENT SPECIFICATION

(11) **EP 4 300 015 B1**
(45) Date of publication and mention of the grant of the patent: **11.12.2024**
(21) Application number: 23177453.0
(22) Date of filing: 06.06.2023
(51) Int. Cl.: F25D 17/02, B23Q 11/14, F25B 25/00, H01L 21/67

(54) **TEMPERATURE CONTROL APPARATUS**
TEMPERATURREGELVORRICHTUNG
APPAREIL DE RÉGULATION DE TEMPÉRATURE

(30) Priority: 28.06.2022 JP 2022103706
(43) Date of publication of application: 03.01.2024
(73) Proprietor: SMC Corporation, Tokyo 101-0021 (JP)
(72) Inventor: AMANO, Tatsuya, Ibaraki, 3002493 (JP); KOJIMA, Takafumi, Ibaraki, 3002493 (JP)
(74) Representative: Keil & Schaafhausen Patentanwälte PartGmbB

(56) References cited:
- JP-A- 2006 283 994
- JP-B2- 3 701 868
- US-A1- 2012 255 352
- US-A1- 2020 318 861

## Description

### Technical Field

The present invention relates to a temperature control apparatus that controls the temperature of a load at a desired temperature by supplying temperature-controlled circulating liquid to the load.

### Background Art

A temperature control apparatus that controls the temperature of a load at a desired temperature by supplying temperature-controlled circulating liquid to the load is already widely known, as disclosed in PTL 1, for example. The temperature control apparatus described in the PTL includes a circulation circuit for circulating circulating liquid to and from a load and a cooling circuit for cooling the circulating liquid. The circulation circuit and the cooling circuit are connected to each other through a tank and a valve.

In some cases, as described in PTL 1, the temperature control apparatus is used to control the load at a temperature that greatly exceeds the boiling point of water (100 °C) under atmospheric pressure in a semiconductor manufacturing device or the like. In temperature control apparatuses in which the circulating liquid is at a high temperature, the temperature difference between the high-temperature circulating liquid and a cooling liquid that cools the circulating liquid becomes significantly large, in particular, in a heat exchanger. Accordingly, it is necessary to take measures to prevent the damage to the heat exchanger caused by the temperature difference.

For this reason, the temperature control apparatus described in PTL 1 employs a heat exchanger with a specialized structure that can withstand such a temperature difference. However, it is expected that a temperature control apparatus is developed that even when the circulating liquid is to be used at high temperatures, the temperature control apparatus can employ a heat exchanger designed in a variety of ways in accordance with user's requirements, such as low cost and high heat efficiency. That is, it is expected that a temperature control apparatus is developed having excellent general versatility and safety in terms of the temperature of the circulating liquid.

### Citation List

### Patent Literature

PTL 1: Japanese Unexamined Patent Application Publication No. 2020-169760

### Summary of Invention

### Technical Problem

A technical problem of the present invention is to provide a temperature control apparatus that has a high degree of freedom in designing a heat exchanger even when the circulating liquid is used at a high temperature and that has excellent general versatility in terms of the temperature of the circulating liquid.

### Solution to Problem

To solve the above-described technical problem, a temperature control apparatus according to the present invention adjusts the temperature of circulating liquid, supplies the circulating liquid to a load that is external, and controls the temperature of the load at a predetermined temperature. The temperature control apparatus includes a circulation circuit, where the circulation circuit includes a main tank storing circulating liquid and including a heater configured to heat the circulating liquid, a discharge flow passage configured to connect the main tank to a circulating liquid discharge port configured to deliver the circulating liquid to the load, a circulation pump configured to deliver the circulating liquid from the main tank to the discharge flow passage, and a return flow passage configured to connect a circulating liquid return port configured to receive the circulating liquid returned from the load to the main tank, a cooling circuit, where the cooling circuit includes a sub-tank storing the circulating liquid, a heat exchanger configured to cool the circulating liquid in the sub-tank by heat exchange with heat dissipating water, a first cooling flow passage configured to connect the sub-tank to the heat exchanger and guide the circulating liquid in the sub-tank to the heat exchanger, a cooling pump configured to deliver the circulating liquid in the sub-tank to the first cooling flow passage, and a second cooling flow passage configured to connect the heat exchanger to the sub-tank and guide the circulating liquid cooled by the heat exchanger to the sub-tank, and a processor configured to control the flow rate of the circulating liquid flowing through the cooling circuit. The sub-tank is connected to the main tank such that when the amount of the circulating liquid in the main tank exceeds a predetermined amount, excessive circulating liquid is led from the main tank to the sub-tank. The second cooling flow passage of the cooling circuit includes a connecting flow passage that branches from the second cooling flow passage and that is connected to the circulation circuit. The circulation circuit includes a temperature sensor configured to measure the temperature of the circulating liquid flowing in the circulation circuit, and the processor controls an output of the cooling pump based on the temperature of the circulating liquid measured by the temperature sensor so as to control the flow rate of the circulating liquid supplied from the inside of the cooling circuit to the inside of the circulation circuit through the connecting flow passage.

In this case, preferably, the main tank includes an opening that leads the excessive circulating liquid out of the main tank to the sub-tank, and the main tank is connected to the sub-tank with the opening positioned higher than a bottom surface of the sub-tank.

In addition, preferably, the processor is configured to switch the cooling pump between a first power output range and a second power output range that is greater than the first power output range on the basis of the temperature of the circulating liquid measured by the temperature sensor and drive the cooling pump. As a result, during driving of the cooling pump in the first power output range, the circulating liquid in the cooling circuit is circulated in the cooling circuit without being supplied to the circulation circuit through the connecting flow passage. In contrast, during driving of the cooling pump in the second power output range, the circulating liquid in the cooling circuit is supplied to the circulation circuit through the connecting flow passage while being circulated in the cooling circuit.

In addition, preferably, the connecting flow passage branches from the second cooling flow passage of the cooling circuit and extends upward.

In addition, preferably, the temperature sensor is a first temperature sensor provided in the discharge flow passage, and the processor compares a preset target temperature with the temperature of the circulating liquid measured by the first temperature sensor. If the measured temperature measured by the first temperature sensor is lower than the target temperature, the processor drives the cooling pump in the first power output range. If the measured temperature measured by the first temperature sensor is higher than the target temperature, the processor drives the cooling pump in the second power output range.

In addition, preferably, the measured temperature measured by the first temperature sensor is lower than the target temperature, the processor further controls the heater and heats the circulating liquid in the main tank.

In addition, preferably, the connecting flow passage includes a second temperature sensor configured to measure the temperature of the circulating liquid. During driving of the cooling pump in the second power output range, the processor calculates a temperature difference between the target temperature and the measured temperature measured by the second temperature sensor, compares the temperature difference with a preset reference value, and decreases the output of the cooling pump within the second power output range with increasing temperature difference from the reference value.

In addition, preferably, the heat exchanger includes a hollow case, at least three heat transfer plates arranged in parallel with a gap therebetween inside the case, a series of first heat exchange flow passages and a series of second heat exchange flow passages alternately formed from the gaps between the heat transfer plates in an arrangement direction of the heat transfer plates, a circulating liquid inlet provided at one end of the first heat exchange flow passage, where the circulating liquid inlet is connected to the first cooling flow passage, a circulating liquid outlet provided at the other end of the first heat exchange flow passage opposite to the circulating liquid inlet, where the circulating liquid outlet is connected to the second cooling flow passage, a heat dissipating water inlet provided at one end of the second heat exchange flow passage, where the heat dissipating water inlet is used to lead heat dissipating water to the second heat exchange flow passage, and a heat dissipating water outlet provided at the other end of the second heat exchange flow passage opposite to the heat dissipating water inlet, where the heat dissipating water outlet is used to discharge the heat dissipating water subjected to heat exchange from the second heat exchange flow passage.

### Advantageous Effects of Invention

In the temperature control apparatus according to the present invention, the heat exchanger does not directly cool a circulating liquid flowing through the circulation circuit connected to the main tank and the heat load and, when the amount of the circulating liquid exceeds a predetermined amount, the heat exchanger cools the excessive circulating liquid that has cooled by the low-temperature circulating liquid in the sub-tank. Therefore, even if the circulating liquid in the circulation circuit is to be used at a high temperature, the temperature difference between the circulating liquid and the cooling liquid in the heat exchanger can be reduced. As a result, according to the present invention, a temperature control apparatus can be provided that has a high degree of freedom in designing the heat exchanger and that is excellent in versatility and safety in terms of the temperature of the circulating liquid.

### Brief Description of Drawings

[Fig. 1] Fig. 1 is a partial cross-sectional perspective view of a temperature control apparatus according to the present invention.
[Fig. 2] Fig. 2 is an internal configuration diagram of a main tank and a sub-tank.
[Fig. 3] Fig. 3 is a cross-sectional perspective view of the upper portion of the temperature control apparatus for describing a circulation circuit.
[Fig. 4] Fig. 4 is a cross-sectional perspective view of the lower portion of the temperature control apparatus for describing a cooling circuit.
[Fig. 5] Fig. 5 is a system configuration diagram of the temperature control apparatus when the temperature of a circulating liquid is lower than a target temperature.
[Fig. 6] Fig. 6 is a system configuration diagram of the temperature control apparatus when the temperature of the circulating liquid is higher than the target temperature.
[Fig. 7] Fig. 7 is an exploded perspective view of a heat exchanger.
[Fig. 8] Fig. 8 is a block diagram of a control unit.

### Description of Embodiments

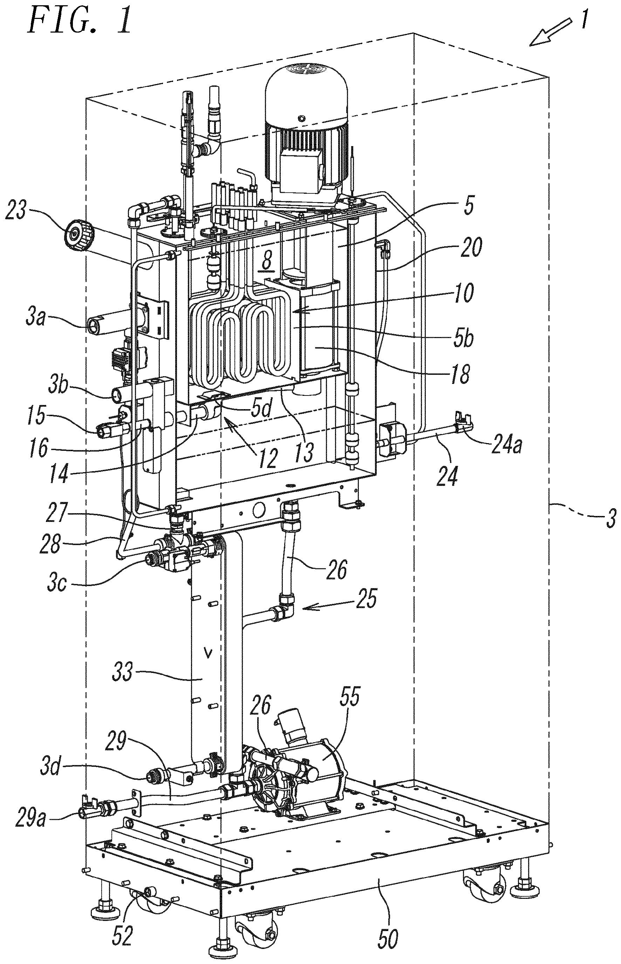

Figs. 1 to 8 illustrate an embodiment of the temperature control apparatus according to the present invention. A temperature control apparatus 1 enables control so that a load that is external (not illustrated) has a predetermined temperature higher than, for example, 100 °C by adjusting the temperature of a circulating liquid having a boiling point higher than 100 °C to a temperature higher than 100 °C and supplying the circulating liquid to the load.

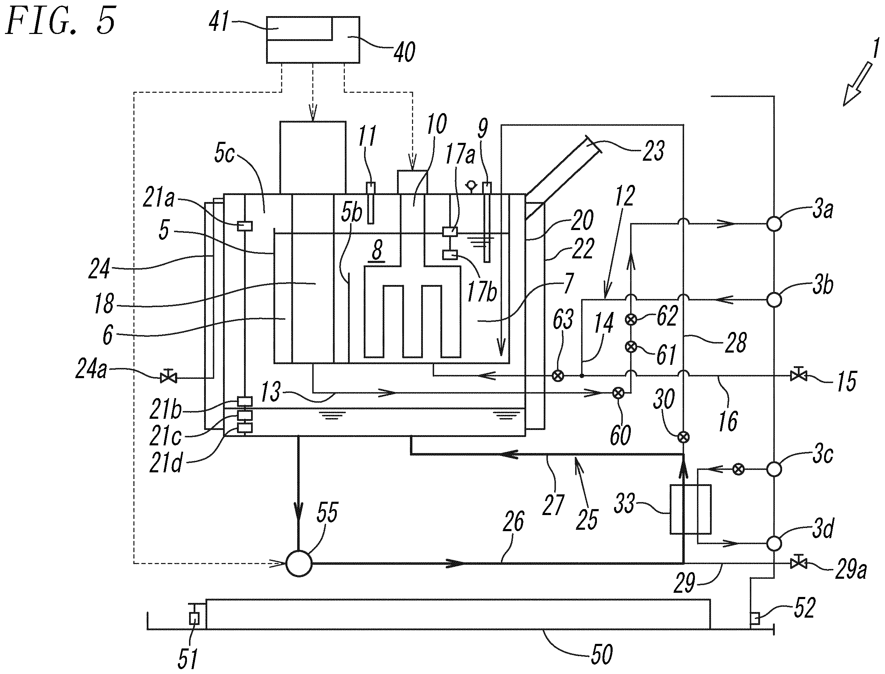

As illustrated in Figs. 1 and 5, the temperature control apparatus 1 (hereinafter referred to as an "apparatus 1") includes a housing 3 that covers the outside of the apparatus 1, a circulation circuit 12 that delivers a circulating liquid from a main tank 5 storing the circulating liquid and including a heater 10 for heating the circulating liquid to an external load (not illustrated) and returns the circulating liquid received from the load back to the main tank 5 again, a cooling circuit 25 that cools, using a heat exchanger 33, the circulating liquid delivered from a sub-tank 20 storing the circulating liquid and returns the circulating liquid to the sub-tank 20 again, and a control unit 40 that controls the flow rate of the circulating liquid flowing through the cooling circuit 25. The cooling circuit 25 includes a connecting flow passage 28 that branches therefrom and is connected to the main tank 5.

The main tank 5, the sub-tank 20, the circulation circuit 12, the heat exchanger 33, the cooling circuit 25 and the control unit 40 are all housed in the housing 3. Furthermore, as is described in detail below, a side surface of the outer circumference of the housing 3 has, formed therein, a circulating liquid discharge port 3a and a circulating liquid return port 3b of the circulation circuit 12 and a cooling liquid supply port 3c and a cooling liquid discharge port 3d for the cooling liquid supplied to the heat exchanger 33. As a result, pipes of a target apparatus (a load) subject to temperature control on a user side can be connected to the openings (the ports) 3a, 3b, 3c, and 3d.

In addition, a drain pan 50 for receiving leaked circulating liquid is disposed on the bottom of the housing 3. The drain pan 50 includes a float-type water leakage sensor 51 electrically connected to the control unit 40 and a drain port 52 for discharging liquid accumulated in the drain pan 50 to the outside. As a result, for example, when the water leakage sensor 51 detects that a large amount of circulating liquid leaks in the apparatus 1, the control unit 40 can send a notification and turn off the power of the apparatus 1.

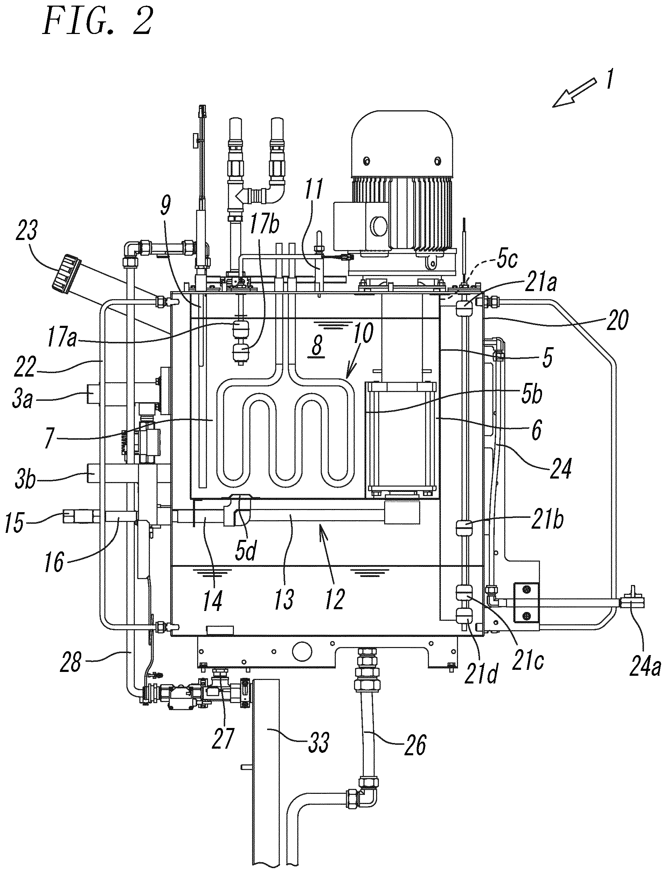

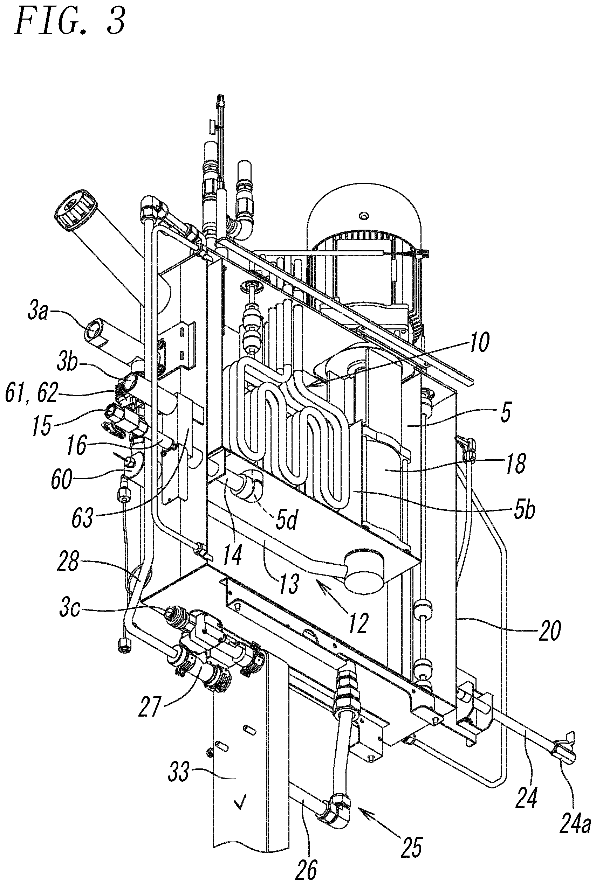

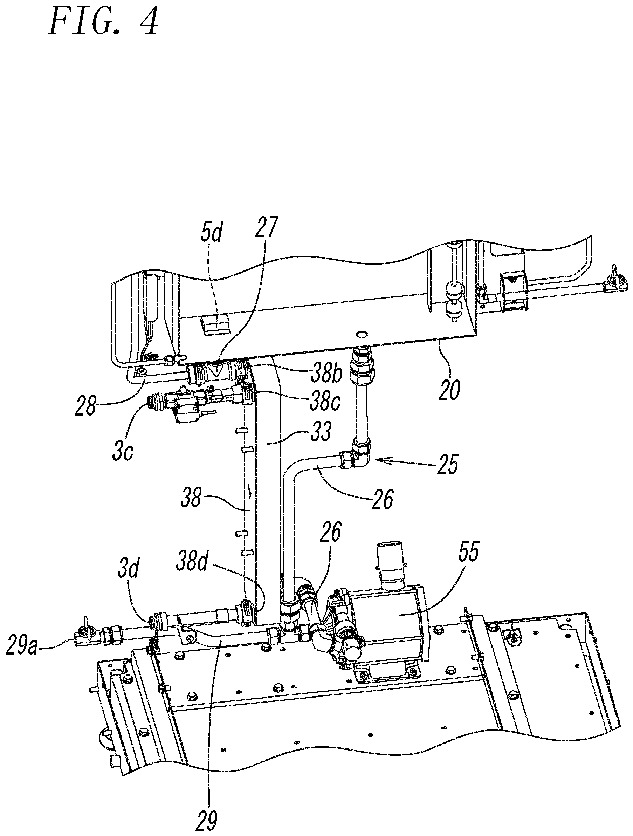

As the circulating liquid, a fluorinated liquid having a boiling point of about 200 °C or higher under atmospheric pressure is used, for example. As the cooling liquid, industrial water having a boiling point of 100 °C under atmospheric pressure is used, for example. According to the present embodiment, as illustrated in Figs. 2 and 3, for example, the circulating liquid having a temperature of 160 °C in the main tank 5 is delivered to the external load through a discharge flow passage 13 of the circulation circuit 12. After performing temperature control on (cooling) the load, the circulating liquid having a temperature of 170 °C is returned to the main tank 5 again through a return flow passage 14 of the circulation circuit 12. In addition, as illustrated in Fig. 4, the cooling liquid having a temperature of 30 °C in the sub-tank 20 is delivered to the cooling circuit 25 and is cooled to 25 °C by the heat exchanger 33. Thereafter, the cooling liquid is returned to the sub-tank 20. Furthermore, according to the present embodiment, the circulating liquid that is cooled to 25 °C by the heat exchanger 33 is also supplied to the main tank 5 through the connecting flow passage 28. In contrast, the cooling liquid supplied to the heat exchanger 33 through the cooling liquid supply port 3c is heated to 27 °C by heat exchange with the circulating liquid and is discharged from the heat exchanger 33 through the cooling liquid discharge port 3d.

As described above, according to the apparatus 1, as illustrated in Fig. 5, the main tank 5 is connected to the circulation circuit 12, the sub-tank 20 is connected to the cooling circuit 25, and the cooling circuit 25 communicates with the main tank 5 via the connecting flow passage 28. That is, the circulation circuit 12 that delivers the circulating liquid to the load that is an object to be temperature-controlled, receives the circulating liquid that has been heated through heat exchange with the load, and returns the circulating liquid to the main tank 5 again communicates through the connecting flow passage 28 with the cooling circuit 25 that cools the cooled circulating liquid in the sub-tank 20 using the heat exchanger 33, returns the circulating liquid to the sub-tank 20 again, and delivers the circulating liquid to the main tank 5 in order to adjust, to a set temperature, the temperature of the circulating liquid delivered from the circulation circuit 12 to the load if the temperature is higher than the set temperature.

According to the present embodiment, as illustrated in Figs. 1 and 2, the main tank 5 is partitioned by a bottom surface, a side surface, and an upper surface, and stores a predetermined depth of the circulating liquid therein. In addition, like the main tank 5, the sub-tank 20 is partitioned by a bottom surface, a side surface, and a top surface and has a volume greater than that of the main tank 5. The sub-tank 20 accommodates the entire main tank 5 and stores an extra supply of circulating liquid.

Inside the main tank 5, a partition wall 5b having a height lower than the aqueous surface of the circulating liquid stored to a predetermined depth is installed upright on the bottom surface of the main tank 5. As a result, the interior of the main tank 5 is divided into two chambers, that is, a first chamber 6 partitioned by one side wall of the main tank 5 and the partition wall 5b and a second chamber 7 partitioned by the partition wall 5b and the other side wall.

Inside the main tank 5, the first chamber 6 and the second chamber 7 communicate with each other through a gap 8 formed in the main tank 5 above the upper end of the partition wall 5b. In addition, an opening 5c is formed at an upper end portion of the side surface of the main tank 5 to open to the sub-tank 20. Thus, the excessive circulating liquid exceeding the maximum capacity of the main tank 5 is discharged into the sub-tank 20. In addition, as illustrated in Fig. 3, a communication port 5d is formed at a lower end portion of the partition wall 5b, so that the circulating liquid in the main tank 5 can be discharged to the outside from a drain cock 15 through the return flow passage 14 connected to the bottom surface of the main tank 5, as described below. Note that the drain cock 15 is attached to the front end portion of a discharge flow passage 16 that branches from the return flow passage 14 and extends toward the other side surface of the housing 3.

As illustrated in Figs. 2 and 5, in the second chamber 7 of the main tank 5, a heater 10 that heats the circulating liquid under control of the control unit 40 is provided in a range from the vicinity of the upper end of the partition wall 5b to the vicinity of the bottom surface of the main tank 5. In addition, in the second chamber 7, a thermostat 9 electrically connected to the control unit 40 is provided in the range from a position having a slight gap above the upper end portion of the partition wall 5b to the liquid level of the circulating liquid in the main tank 5 when the maximum capacity of circulating liquid is stored in the main tank 5 (that is, the highest liquid level of circulating liquid). This enables the heater 10 to be turned off when the temperature of the circulating liquid exceeds a predetermined temperature, for example. Furthermore, in the second chamber 7, a temperature fuse 11 electrically connected to the control unit 40 is provided between the highest liquid level of the circulating liquid and the upper surface of the main tank 5. As a result, for example, when the temperature of the air (the air temperature) in the main tank 5 becomes higher than a predetermined temperature, it can be determined that the circulating liquid is in an overheated state and, thus, the power of the apparatus 1 can be turned OFF, for example. Furthermore, two upper and lower level switches 17a and 17b are provided above the upper end portion of the partition wall 5b of the second chamber 7, and the level switches 17a and 17b are also electrically connected to the control unit 40. Thus, the level of the circulating liquid (the liquid level) in the main tank 5 can be detected by the level switches 17a and 17b.

The first chamber 6 of the main tank 5 is provided with an immersion type circulation pump 18 that delivers the circulating liquid to the circulation circuit 12. The circulation pump 18 is also controlled by the control unit 40. Note that according to the present embodiment, inverter-controlled pumps are used as the circulation pump 18 and a cooling pump 55 (described below).

A total of four level switches 21a, 21b, 21c, and 21d are provided inside the sub-tank 20: one above the center in the depth direction of the sub-tank 20 and three arranged in the vertical direction below the center. The level switches 21a to 21d are also electrically connected to the control unit 40. Furthermore, a level gauge 22 for visually checking the amount of circulating liquid in the sub-tank 20 from outside the housing 3 and a circulating liquid fill port 23 for refilling the circulating liquid from outside the housing 3 to the sub-tank 20 are provided on the outer periphery of the sub-tank 20. In addition, a filling pipe 24 with its upper end connected to the side surface of the sub-tank 20 is provided on the side surface so as to extend downward, and a drain cock 24a is attached to an end portion of the filling pipe 24. By opening the drain cock 24a, the drain cock 24a functions as a fill port for the circulating liquid, and the circulating liquid can be pumped into the sub-tank 20. Then, the four level switches 21a, 21b, 21c, and 21d detect the level (the liquid level) of the circulating liquid in the sub-tank 20, thus prompting a user to refill the sub-tank 20 with circulating liquid through the circulating liquid fill port 23 or refill the sub-tank 20 with circulating liquid by opening the drain cock 24a.

As illustrated in Figs. 3 and 5, the circulation circuit 12 includes the main tank 5, the discharge flow passage 13 that connects the first chamber 6 of the main tank 5 to the circulating liquid discharge port 3a that delivers the circulating liquid to the load, the circulation pump 18 that delivers the circulating liquid from the main tank 5 to the discharge flow passage 13, and the return flow passage 14 that connects the circulating liquid return port 3b for receiving the circulating liquid returned from the load to the second chamber 7 of the main tank 5. Then, the circulating liquid in the first chamber 6 of the main tank 5 is delivered to the load by the circulation pump 18 through the discharge flow passage 13 and the circulating liquid discharge port 3a, and the circulating liquid that has controlled temperature of the load is returned to the main tank 5 again through the circulating liquid return port 3b and the return flow passage 14.

At this time, the return flow passage 14 is connected to the second chamber 7 having the heater 10 disposed therein on the upstream side in the main tank 5. According to the configuration, even if the temperature of the circulating liquid returned from the return flow passage 14 to the main tank 5 changes, the circulating liquid returned to the second chamber 7 is subjected to temperature control by the heater 10 and the circulating liquid from the cooling circuit 25 and is delivered to the discharge flow passage 13, so that the circulating liquid having a more accurately adjusted temperature can be supplied to the load.

The discharge flow passage 13 has a pressure sensor 60, a first temperature sensor (temperature sensor) 61, and a flow rate sensor 62 disposed therein from the upstream side to the downstream side, and a third temperature sensor 63 is provided in the return flow passage 14. The pressure sensor 60, the first and third temperature sensors 61 and 63, and the flow rate sensor 62 are all electrically connected to the control unit 40. As a result, the heater 10, the cooling pump 55, and the circulation pump 18 can be appropriately controlled on the basis of the measured values from the sensors 60 to 63, for example.

As illustrated in Figs. 4 and 5, the cooling circuit 25 includes the sub-tank 20 storing the circulating liquid, the heat exchanger 33 for cooling the circulating liquid in the sub-tank 20 by heat exchange with a heat dissipating liquid, a first cooling flow passage 26 that connects the sub-tank 20 to the heat exchanger 33 and guides the circulating liquid in the sub-tank 20 to the heat exchanger 33, the cooling pump 55 that delivers the circulating liquid in the sub-tank 20 to the first cooling flow passage 26, and a second cooling flow passage 27 that connects the heat exchanger 33 to the sub-tank 20 and guides the circulating liquid cooled by the heat exchanger 33 to the sub-tank 20. Then, the circulating liquid in the sub-tank 20 flows into the heat exchanger 33 through the first cooling flow passage 26 by the cooling pump 55 provided in the first cooling flow passage 26, and the circulating liquid that is cooled by the heat exchanger 33 and that flows out of the heat exchanger 33 is returned to the main tank 5 again through the second cooling flow passage 27.

As illustrated in Figs. 2, 4 and 6, the second cooling flow passage 27 is provided with the connecting flow passage 28 that branches from the second cooling flow passage 27 and communicates with the main tank 5 of the circulation circuit 12. According to the present embodiment, the connecting flow passage 28 communicates with the second chamber 7 of the main tank 5. As a result, when the temperature of the circulating liquid returned from the return flow passage 14 of the circulation circuit 12 to the main tank 5 is higher than a set value, the circulating liquid in the main tank 5 is cooled by the circulating liquid supplied from the connecting flow passage 28 and, thus, is subjected to temperature control. Thereafter, the circulating liquid is delivered from the first chamber 6 located most downstream to the discharge flow passage 13. As a result, the circulating liquid having a temperature adjusted to a more accurate temperature can be supplied to a load.

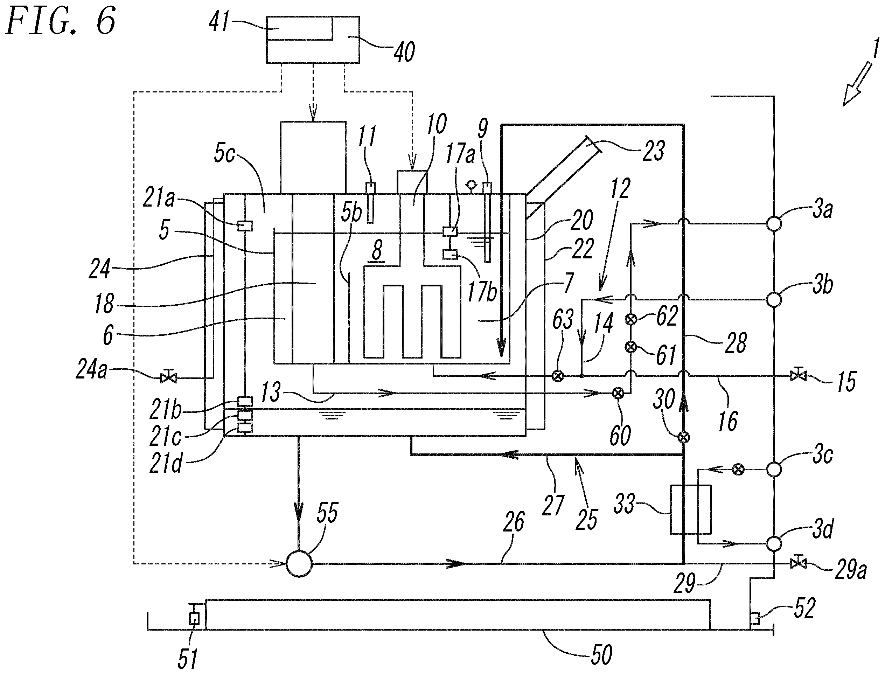

As illustrated in Figs. 4 and 6, the first cooling flow passage 26 has, connected thereto, a drainpipe 29 that branches therefrom, and the front end of the drainpipe 29 is led out of the housing 3. A drain cock 29a is provided at the front end of the drainpipe 29, and the circulating liquid in the cooling circuit 25 can be discharged to the outside by opening the drain cock 29a. The connecting flow passage 28 has a second temperature sensor 30 therein (refer to Fig. 6), and the second temperature sensor 30 is also electrically connected to the control unit 40. As a result, the rotational speed of the cooling pump 55 can be controlled by the control unit 40 in accordance with the temperature of the circulating liquid detected by the second temperature sensor 30 (the details are described below).

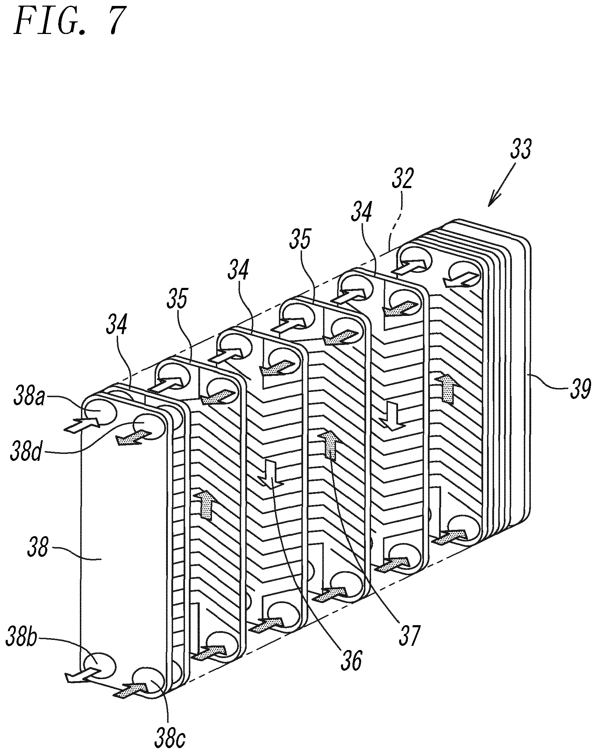

As illustrated in Fig. 7, the heat exchanger 33 is a plate heat exchanger. Two types of heat transfer plates 34 and 35 have different irregularity patterns formed on the surfaces thereof, and a plurality of heat transfer plates 34 and 35 are alternately stacked and integrated by, for example, brazing or bolt fastening and are accommodated in a hollow case 32. A first heat exchange flow passage 36 and a second heat exchange flow passage 37 each formed by a narrow gap between adjacent heat transfer plates 34 and 35 are alternately disposed with a wall that is one of the heat transfer plates 34 and 35 therebetween. The circulating liquid for the cooling circuit 25 flows through the first heat exchange flow passage 36, while the cooling liquid for cooling the circulating liquid flows through the second heat exchange flow passage 37. According to the present embodiment, cover plates 38 and 39 that form a pair are provided at either end of the stack of two types of heat transfer plates 34 and 35 that are alternately stacked. A circulating liquid inlet 38a serving as an inlet of the first heat exchange flow passage 36, a circulating liquid outlet 38b serving as an outlet of the first heat exchange flow passage 36, a cooling liquid inlet 38c serving as an inlet of the second heat exchange flow passage 37, and a cooling liquid outlet 38d serving as an outlet of the second heat exchange flow passage 37 are formed in one of the cover plates 38 and 39. Note that in the heat exchanger 33 illustrated in Fig. 4 according to the present embodiment, the circulating liquid outlet 38b, the cooling liquid inlet 38c, and the cooling liquid outlet 38d are formed to open in the cover plate 38, which is one of the two cover plates, and the circulating liquid inlet 38a is formed to open in the cover plate 39, which is the other cover plate.

The circulating liquid that has entered from the circulating liquid inlet 38a passes through the first heat exchange flow passage 36 and exits from the circulating liquid outlet 38b. In contrast, the cooling liquid that has entered from the cooling liquid inlet 38c passes through the second heat exchange flow passage 37 and exits from the cooling liquid outlet 38d. Since the plate heat exchanger 33 having such a configuration exchanges heat between the circulating liquid and the cooling liquid in a complete counterflow manner, the heat exchanger 33 has advantages of high performance and extremely high thermal efficiency. In addition, the heat exchanger 33 is compact and lightweight, and can be installed in a small area.

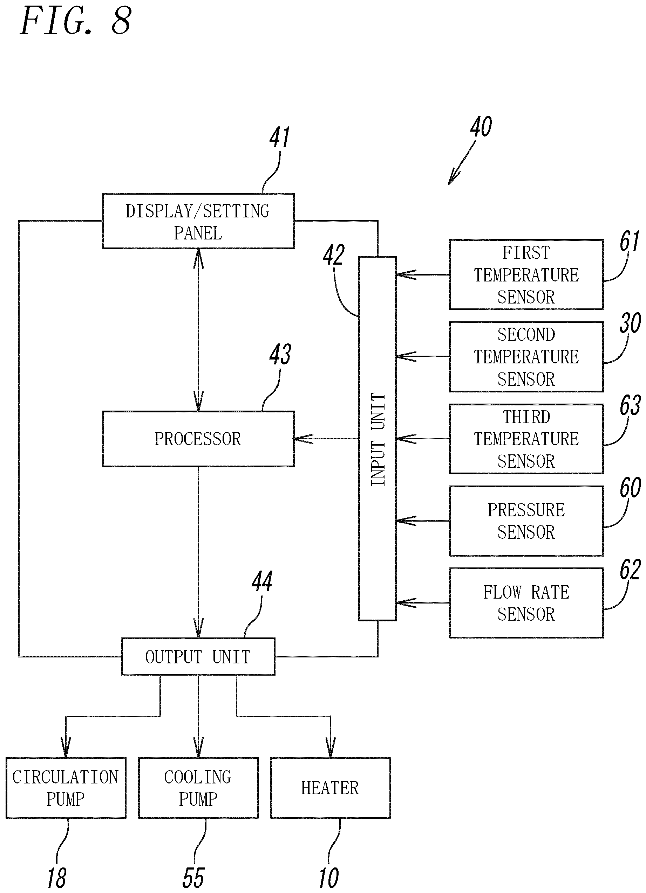

As illustrated in Figs. 5 and 8, the control unit 40 includes a display/setting panel 41 for appropriately setting the temperature of the circulating liquid to be delivered to the load through the discharge flow passage 13 of the circulation circuit 12, an input unit 42 for receiving the measurement values of the temperature sensors 30, 61, and 63, a processor 43 for controlling the temperature, flow rate, or the like of the circulating liquid flowing through the circulation circuit 12 and the cooling circuit 25, and an output unit 44 for outputting a control signal from the processor 43 to an object to be controlled, such as the circulation pump 18.

The setting item preset on the display/setting panel 41 is a delivery temperature, which is the target temperature of the circulating liquid supplied to the load. According to the present embodiment, the set value of the delivery temperature of the circulating liquid is, for example, 160 °C, and the set value is input from the display/setting panel 41. Therefore, a method for controlling the cooling pump 55 and the circulation pump 18 using the control unit 40 in terms of the set temperature of the circulating liquid is described below with reference to Figs. 5 and 6.

First, when the delivery temperature (the measured temperature) of the circulating liquid measured by the first temperature sensor 61 in the discharge flow passage 13 is lower than the set temperature, the inverter control cooling pump 55 is driven in a low rotational speed range (a first power output range) by the processor 43 of the control unit 40, and the rotational speed is maintained at a predetermined low rotational speed (low frequency), as illustrated in Fig. 5. Then, the heater 10 is turned on by the processor 43 to heat the circulating liquid in the main tank 5. Until the measured temperature of the circulating liquid in the circulation circuit 12 measured by the first temperature sensor 61 reaches the target temperature, the cooling pump 55 is continuously driven in the first power output range. In addition, the circulation pump 18 that delivers the circulating liquid in the main tank 5 to the load through the discharge flow passage 13 is controlled by the processor 43 to rotate at a rotational speed so that the measured value of one of the pressure sensor 60 and the flow rate sensor 62 is a predetermined set value.

When the measured temperature of the circulating liquid measured by the first temperature sensor 61 exceeds the target temperature, the heater 10 is turned OFF, and the driving of the cooling pump 55 is switched to driving in a high rotational speed range (a second power output range) to maintain a predetermined high rotational speed (high frequency) by the processor 43, as illustrated in Fig. 6. In addition, the rotational speed of the circulation pump 18 is maintained at such a rotational speed that the measured value of one of the pressure sensor 60 and the flow rate sensor 62 is a predetermined set value. As a result, the flow rate of the circulating liquid flowing through the cooling circuit 25 increases, and part of the circulating liquid discharged from the heat exchanger 33 flows through the connecting flow passage 28 and is supplied into the main tank 5. Thus, the circulating liquid in the main tank 5 is cooled. Then, the cooled circulating liquid in the main tank 5 is supplied to the load through the discharge flow passage 13. Until the measured temperature of the circulating liquid in the discharge flow passage 13 measured by the first temperature sensor 61 reaches the target temperature, the driving of the cooling pump 55 in the second power output range is maintained, and the circulating liquid in the sub-tank 20 is supplied to the main tank 5.

If the amount of circulating liquid in the main tank 5 exceeds a predetermined amount while the circulating liquid in the sub-tank 20 is being supplied to the main tank 5, an excessive circulating liquid flows into the sub-tank 20 through the opening 5c so that the temperature is decreased due to the low-temperature circulating liquid, and the temperature-lowered circulating liquid is cooled by the heat exchanger 33. Part of the circulating liquid cooled by the heat exchanger 33 is returned to the sub-tank 20, and the other circulating liquid is supplied to the main tank 5 through the connecting flow passage 28. Therefore, in the heat exchanger 33, since the temperature of the circulating liquid flowing into the heat exchanger 33 is decreased, the temperature difference between the circulating liquid and the cooling liquid to be heat-exchanged with the circulating liquid can be reduced.

Herein, the processor 43 may calculate the temperature difference between the target temperature of the circulating liquid flowing through the discharge flow passage 13 and the temperature measured by the second temperature sensor 30 while the cooling pump 55 is driven in the second power output range, compare the temperature difference with a preset reference value, and decrease the output of the cooling pump 55 within the second power output range as the temperature difference increases from the reference value. When the measured temperature of the circulating liquid flowing through the connecting flow passage 28 changes, the calculated temperature difference also changes, and the difference from the reference value also changes. Since the temperature of the circulating liquid flowing the connecting flow passage 28 decreases and the cold energy increases with increasing difference between the temperature difference and the reference value, the flow rate of the circulating liquid for cooling the high-temperature circulating liquid accumulated in the main tank 5 can be decreased. However, since the temperature of the circulating liquid flowing through the connecting flow passage 28 increases with decreasing difference between the temperature difference and the reference value and, thus, the cold energy decreases, it is necessary to increase the flow rate of the circulating liquid for cooling the high-temperature circulating liquid accumulated in the main tank 5. For this reason, when the temperature difference becomes greater than the reference value, the flow rate of the circulating liquid supplied to the main tank 5 can be decreased, so that the output of the cooling pump 55 can be reduced within the second power output range.

Note that the processor 43 may turn on the heater 10 when the third temperature sensor 63 detects that the temperature of the circulating liquid that flows through the return flow passage 14 and that is returned from the load is lower than a preset temperature. As a result, the circulating liquid returned from the load can be rapidly heated by the heater 10.

As described above, according to the present embodiment, the heat exchanger 33 does not directly cool the circulating liquid flowing through the circulation circuit 12 connected to the load and, when the amount of circulating liquid in the main tank 5 exceeds a predetermined amount, the heat exchanger 33 cools the excessive circulating liquid that has been cooled by the low-temperature circulating liquid in the sub-tank 20. For this reason, even if the circulating liquid in the circulation circuit 12 is to be used at high temperature, the temperature difference between the circulating liquid in the heat exchanger 33 and the cooling liquid for the circulating liquid can be reduced. As a result, even when the circulating liquid is to be used at high temperature, the temperature control apparatus 1 can be provided that has a high degree of freedom in designing (selecting) the heat exchanger 33 and that has excellent general versatility in terms of the temperature of the circulating liquid. Reference Signs List

- 1: temperature control apparatus
- 3a: circulating liquid discharge port
- 3b: circulating liquid return port
- 5: main tank
- 5c: opening
- 10: heater
- 12: circulation circuit
- 13: discharge flow passage
- 14: return flow passage
- 18: circulation pump
- 20: sub-tank
- 25: cooling circuit
- 26: first cooling flow passage
- 27: second cooling flow passage
- 28: connecting flow passage
- 30: second temperature sensor
- 32: case
- 33: heat exchanger
- 34, 35: heat transfer plate
- 36: first heat exchange flow passage
- 37: second heat exchange flow passage
- 38a: circulating liquid inlet
- 38b: circulating liquid outlet
- 38c: cooling liquid inlet
- 38d: cooling liquid outlet
- 43: processor
- 55: cooling pump
- 61: first temperature sensor (temperature sensor)

## Claims

1. A temperature control apparatus (1) for adjusting the temperature of circulating liquid, supplying the circulating liquid to a load that is external, and controlling the temperature of the load to a predetermined temperature, the temperature control apparatus comprising:
a circulation circuit (12), wherein the circulation circuit includes a main tank (5) storing circulating liquid and including a heater (10) configured to heat the circulating liquid, a discharge flow passage (13) configured to connect the main tank to a circulating liquid discharge port (3a) configured to deliver the circulating liquid to the load, a circulation pump (18) configured to deliver the circulating liquid from the main tank to the discharge flow passage, and a return flow passage (14) configured to connect a circulating liquid return port (3b) configured to receive the circulating liquid returned from the load to the main tank;
a cooling circuit (25), wherein the cooling circuit includes a sub-tank (20) storing the circulating liquid, a heat exchanger (33) configured to cool the circulating liquid in the sub-tank by heat exchange with heat dissipating water, a first cooling flow passage (26) configured to connect the sub-tank to the heat exchanger and guide the circulating liquid in the sub-tank to the heat exchanger, a cooling pump (55) configured to deliver the circulating liquid in the sub-tank to the first cooling flow passage, and a second cooling flow passage (27) configured to connect the heat exchanger to the sub-tank and guide the circulating liquid cooled by the heat exchanger to the sub-tank; and
a processor (43) configured to control the flow rate of the circulating liquid flowing through the cooling circuit,
wherein the sub-tank is connected to the main tank such that when an amount of the circulating liquid in the main tank exceeds a predetermined amount, excessive circulating liquid is led from the main tank to the sub-tank,
wherein the second cooling flow passage of the cooling circuit includes a connecting flow passage (28) that branches from the second cooling flow passage and that is connected to the circulation circuit,
wherein the circulation circuit includes a temperature sensor (61, 30) configured to measure the temperature of the circulating liquid flowing in the circulation circuit, and
wherein the processor controls an output of the cooling pump based on the temperature of the circulating liquid measured by the temperature sensor so as to control the flow rate of the circulating liquid supplied from the inside of the cooling circuit to the inside of the circulation circuit through the connecting flow passage.

2. The temperature control apparatus according to Claim 1, wherein the main tank includes an opening (5c) that leads the excessive circulating liquid out of the main tank to the sub-tank, and
wherein the main tank is connected to the sub-tank with the opening positioned higher than a bottom surface of the sub-tank.

3. The temperature control apparatus according to Claim 1, wherein the processor is configured to switch the cooling pump between a first power output range and a second power output range that is greater than the first power output range on the basis of the temperature of the circulating liquid measured by the temperature sensor and drive the cooling pump, and
wherein as a result of the switching, during driving of the cooling pump in the first power output range, the circulating liquid in the cooling circuit is circulated in the cooling circuit without being supplied to the circulation circuit through the connecting flow passage and, during driving of the cooling pump in the second power output range, the circulating liquid in the cooling circuit is supplied to the circulation circuit through the connecting flow passage while being circulated in the cooling circuit.

4. The temperature control apparatus according to Claim 3, wherein the connecting flow passage branches from the second cooling flow passage of the cooling circuit and extends upward.

5. The temperature control apparatus according to Claim 3 or 4, wherein the temperature sensor is a first temperature sensor (61) provided in the discharge flow passage,
wherein the processor compares a preset target temperature with the temperature of the circulating liquid measured by the first temperature sensor,
wherein if the measured temperature measured by the first temperature sensor is lower than the target temperature, the processor drives the cooling pump in the first power output range, and
wherein if the measured temperature measured by the first temperature sensor is higher than the target temperature, the processor drives the cooling pump in the second power output range.

6. The temperature control apparatus according to Claim 5, wherein the measured temperature measured by the first temperature sensor is lower than the target temperature, the processor further controls the heater and heats the circulating liquid in the main tank.

7. The temperature control apparatus according to Claim 5, wherein the connecting flow passage includes a second temperature sensor (30) configured to measure the temperature of the circulating liquid, and
wherein during driving of the cooling pump in the second power output range, the processor calculates a temperature difference between the target temperature and the measured temperature measured by the second temperature sensor, compares the temperature difference with a preset reference value, and decreases the output of the cooling pump within the second power output range with increasing temperature difference from the reference value.

8. The temperature control apparatus according to Claim 1, wherein the heat exchanger includes a hollow case (32), at least three heat transfer plates (34, 35) arranged in parallel with a gap therebetween inside the case, a series of first heat exchange flow passages (36) and a series of second heat exchange flow passages (37) alternately formed from the gaps between the heat transfer plates in an arrangement direction of the heat transfer plates, a circulating liquid inlet (38a) provided at one end of the first heat exchange flow passage, wherein the circulating liquid inlet is connected to the first cooling flow passage, a circulating liquid outlet (38b) provided at the other end of the first heat exchange flow passage opposite to the circulating liquid inlet, wherein the circulating liquid outlet is connected to the second cooling flow passage, a heat dissipating water inlet (38c) provided at one end of the second heat exchange flow passage, wherein the heat dissipating water inlet is used to lead heat dissipating water to the second heat exchange flow passage, and a heat dissipating water outlet (38d) provided at the other end of the second heat exchange flow passage opposite to the heat dissipating water inlet, wherein the heat dissipating water outlet is used to discharge the heat dissipating water subjected to heat exchange from the second heat exchange flow passage.

## Patentansprüche

1. Temperaturregelvorrichtung (1) zum Einstellen der Temperatur einer zirkulierenden Flüssigkeit, zum Zuführen der zirkulierenden Flüssigkeit zu einer externen Last und zum Regeln der Temperatur der Last auf eine vorbestimmte Temperatur, wobei die Temperaturregelvorrichtung umfasst:
einen Zirkulationskreislauf (12), wobei der Zirkulationskreislauf einen Haupttank (5), der die Zirkulationsflüssigkeit speichert und eine Heizvorrichtung (10) enthält, die so konfiguriert ist, dass sie die Zirkulationsflüssigkeit erwärmt, einen Auslassströmungskanal (13), der so konfiguriert ist, dass er den Haupttank mit einer Zirkulationsflüssigkeitsauslassöffnung (3a) verbindet, die so konfiguriert ist, dass sie die Zirkulationsflüssigkeit an die Last liefert, eine Zirkulationspumpe (18), die so konfiguriert ist, dass sie die Zirkulationsflüssigkeit vom Haupttank zum Auslassströmungskanal liefert, und einen Rückströmungskanal (14), der so konfiguriert ist, dass er eine Zirkulationsflüssigkeitsrückführöffnung (3b), die so konfiguriert ist, dass sie die von der Last zurückgeführte Zirkulationsflüssigkeit aufnimmt, mit dem Haupttank verbindet, umfasst;
einen Kühlkreislauf (25), wobei der Kühlkreislauf einen Nebentank (20), der die zirkulierende Flüssigkeit speichert, einen Wärmetauscher (33), der so konfiguriert ist, dass er die zirkulierende Flüssigkeit im Nebentank durch Wärmeaustausch mit wärmeableitendem Wasser kühlt, einen ersten Kühlströmungskanal (26), der so konfiguriert ist, dass er den Nebentank mit dem Wärmetauscher verbindet und die zirkulierende Flüssigkeit im Nebentank zum Wärmetauscher leitet, eine Kühlpumpe (55), die so konfiguriert ist, dass sie die zirkulierende Flüssigkeit im Nebentank zum ersten Kühlströmungskanal befördert, und einen zweiten Kühlströmungskanal (27), der so konfiguriert ist, dass er den Wärmetauscher mit dem Nebentank verbindet und die vom Wärmetauscher gekühlte zirkulierende Flüssigkeit zum Nebentank leitet; und
einen Prozessor (43), der so konfiguriert ist, dass er die Strömungsrate der durch den Kühlkreislauf strömenden zirkulierenden Flüssigkeit steuert,
wobei der Nebentank mit dem Haupttank verbunden ist, so dass, wenn eine Menge der zirkulierenden Flüssigkeit im Haupttank eine vorbestimmte Menge überschreitet, überschüssige zirkulierende Flüssigkeit vom Haupttank zum Nebentank geleitet wird,
wobei der zweite Kühlströmungskanal des Kühlkreislaufs einen Verbindungsströmungskanal (28) umfasst, der vom zweiten Kühlströmungskanal abzweigt und mit dem Zirkulationskreislauf verbunden ist,
wobei der Zirkulationskreislauf einen Temperatursensor (61, 30) umfasst, der so konfiguriert ist, dass er die Temperatur der im Zirkulationskreislauf fließenden zirkulierenden Flüssigkeit misst, und
wobei der Prozessor eine Ausgabe der Kühlpumpe auf der Grundlage der vom Temperatursensor gemessenen Temperatur der zirkulierenden Flüssigkeit steuert, um die Durchflussrate der zirkulierenden Flüssigkeit zu steuern, die vom Inneren des Kühlkreislaufs zum Inneren des Zirkulationskreislaufs durch den Verbindungsströmungskanal zugeführt wird.

2. Temperaturregelvorrichtung nach Anspruch 1, wobei der Haupttank eine Öffnung (5c) aufweist, die die überschüssige zirkulierende Flüssigkeit aus dem Haupttank in den Nebentank leitet, und
wobei der Haupttank mit dem Nebentank verbunden ist, wobei die Öffnung höher als eine Bodenfläche des Nebentanks positioniert ist.

3. Temperaturregelvorrichtung nach Anspruch 1, wobei der Prozessor so konfiguriert ist, dass er die Kühlpumpe zwischen einem ersten Leistungsausgangsbereich und einem zweiten Leistungsausgangsbereich, der größer als der erste Leistungsausgangsbereich ist, auf der Grundlage der von dem Temperatursensor gemessenen Temperatur der zirkulierenden Flüssigkeit umschaltet und die Kühlpumpe antreibt, und
wobei als Ergebnis des Umschaltens während des Antriebs der Kühlpumpe im ersten Leistungsausgangsbereich die zirkulierende Flüssigkeit im Kühlkreislauf im Kühlkreislauf zirkuliert wird, ohne dem Zirkulationskreislauf durch den Verbindungsströmungsdurchgang zugeführt zu werden, und während des Antriebs der Kühlpumpe im zweiten Leistungsausgangsbereich die zirkulierende Flüssigkeit im Kühlkreislauf dem Zirkulationskreislauf durch den Verbindungsströmungsdurchgang zugeführt wird, während sie im Kühlkreislauf zirkuliert wird.

4. Temperaturregelvorrichtung nach Anspruch 3, wobei der Verbindungsströmungskanal vom zweiten Kühlströmungskanal des Kühlkreislaufs abzweigt und sich nach oben erstreckt.

5. Temperaturregelvorrichtung nach Anspruch 3 oder 4, wobei der Temperatursensor ein erster Temperatursensor (61) ist, der im Auslassströmungskanal vorgesehen ist,
wobei der Prozessor eine voreingestellte Solltemperatur mit der vom ersten Temperatursensor gemessenen Temperatur der zirkulierenden Flüssigkeit vergleicht,
wobei, wenn die vom ersten Temperatursensor gemessene Temperatur niedriger als die Zieltemperatur ist, der Prozessor die Kühlpumpe im ersten Leistungsausgangsbereich betreibt, und
wobei, wenn die vom ersten Temperatursensor gemessene Temperatur höher als die Zieltemperatur ist, der Prozessor die Kühlpumpe im zweiten Leistungsausgangsbereich betreibt.

6. Temperaturregelvorrichtung nach Anspruch 5, wobei die vom ersten Temperatursensor gemessene Temperatur niedriger als die Solltemperatur ist, wobei der Prozessor ferner die Heizvorrichtung steuert und die zirkulierende Flüssigkeit im Haupttank erwärmt.

7. Temperaturregelvorrichtung nach Anspruch 5, wobei der Verbindungsströmungskanal einen zweiten Temperatursensor (30) umfasst, der so konfiguriert ist, dass er die Temperatur der zirkulierenden Flüssigkeit misst, und
wobei während des Betriebs der Kühlpumpe im zweiten Leistungsausgangsbereich der Prozessor eine Temperaturdifferenz zwischen der Solltemperatur und der vom zweiten Temperatursensor gemessenen Temperatur berechnet, die Temperaturdifferenz mit einem voreingestellten Referenzwert vergleicht und die Leistung der Kühlpumpe innerhalb des zweiten Leistungsausgangsbereichs mit zunehmender Temperaturdifferenz vom Referenzwert verringert.

8. Temperaturregelvorrichtung nach Anspruch 1, wobei der Wärmetauscher ein hohles Gehäuse (32), mindestens drei parallel mit einem Spalt dazwischen im Gehäuse angeordnete Wärmeübertragungsplatten (34, 35), eine Reihe erster Wärmetausch-Strömungskanäle (36) und eine Reihe zweiter Wärmetausch-Strömungskanäle (37), die abwechselnd aus den Spalten zwischen den Wärmeübertragungsplatten in einer Anordnungsrichtung der Wärmeübertragungsplatten gebildet sind, einen an einem Ende des ersten Wärmetausch-Strömungskanals vorgesehenen Zirkulationsflüssigkeitseinlass (38a), wobei der Zirkulationsflüssigkeitseinlass mit dem ersten Kühl-Strömungskanal verbunden ist, einen Zirkulationsflüssigkeitsauslass (38b), der am anderen Ende des ersten Wärmetausch-Strömungskanals gegenüber dem Zirkulationsflüssigkeitseinlass vorgesehen ist, wobei der Zirkulationsflüssigkeitsauslass mit dem zweiten Kühl-Strömungskanal verbunden ist, einen Wärmeableitungswassereinlass (38c), der an einem Ende des zweiten Wärmetausch-Strömungskanals vorgesehen ist, wobei der Wärmeableitungswassereinlass dazu verwendet wird, Wärmeableitungswasser zum zweiten Wärmetausch-Strömungskanal zu leiten, und einen Wärmeableitungswasserauslass (38d), der am anderen Ende des zweiten Wärmetausch-Strömungskanals gegenüber dem Wärmeableitungswassereinlass vorgesehen ist, wobei der Wärmeableitungswasserauslass dazu verwendet wird, das Wärmeableitungswasser, das dem Wärmeaustausch unterzogen wurde, aus dem zweiten Wärmetausch-Strömungskanal abzuführen.

## Revendications

1. Appareil de régulation de température (1) destiné à ajuster la température d'un liquide circulant, à alimenter le liquide circulant vers une charge externe, et à réguler la température de la charge à une température prédéterminée, l'appareil de régulation de température comprenant :
un circuit de circulation (12),
dans lequel le circuit de circulation inclut un réservoir principal (5) stockant du liquide circulant et incluant un moyen de chauffage (10) configuré pour chauffer le liquide circulant, un passage d'écoulement de décharge (13) configuré pour raccorder le réservoir principal à un orifice de décharge de liquide circulant (3a) configuré pour distribuer le liquide circulant à la charge, une pompe de circulation (18) configurée pour distribuer le liquide circulant à partir du réservoir principal vers le passage d'écoulement de décharge, et un passage d'écoulement de retour (14) configuré pour raccorder un orifice de retour de liquide circulant (3b) configuré pour recevoir le liquide circulant renvoyé à partir de la charge vers le réservoir principal ;
un circuit de refroidissement (25),
dans lequel le circuit de refroidissement inclut un sous-réservoir (20) stockant le liquide circulant, un échangeur de chaleur (33) configuré pour refroidir le liquide circulant dans le sous-réservoir par échange de chaleur avec de l'eau de dissipation de chaleur, un premier passage d'écoulement de refroidissement (26) configuré pour raccorder le sous-réservoir à l'échangeur de chaleur et pour guider le liquide circulant dans le sous-réservoir vers l'échangeur de chaleur, une pompe de refroidissement (55) configurée pour distribuer le liquide circulant dans le sous-réservoir au premier passage d'écoulement de refroidissement, et un deuxième passage d'écoulement de refroidissement (27) configuré pour raccorder l'échangeur de chaleur au sous-réservoir et pour guider le liquide circulant refroidi par l'échangeur de chaleur vers le sous-réservoir ; et
un processeur (43) configuré pour réguler le débit du liquide circulant s'écoulant à travers le circuit de refroidissement,
dans lequel le sous-réservoir est raccordé au réservoir principal de telle façon que lorsqu'une quantité du liquide circulant dans le réservoir principal dépasse une quantité prédéterminée, le liquide circulant excédentaire est conduit à partir du réservoir principal vers le sous-réservoir,
dans lequel le deuxième passage d'écoulement de refroidissement du circuit de refroidissement inclut un passage d'écoulement de raccordement (28) bifurquant à partir du deuxième passage d'écoulement de refroidissement et raccordé au circuit de circulation,
dans lequel le circuit de circulation inclut un capteur de température (61, 30) configuré pour mesurer la température du liquide circulant s'écoulant dans le circuit de circulation, et
dans lequel le processeur régule une sortie de la pompe de refroidissement sur la base de la température du liquide circulant mesurée par le capteur de température, de manière à réguler le débit du liquide circulant alimenté depuis l'intérieur du circuit de refroidissement vers l'intérieur du circuit de circulation à travers le passage d'écoulement de raccordement.

2. Appareil de régulation de température selon la revendication 1, dans lequel le réservoir principal inclut une ouverture (5c) conduisant le liquide circulant excédentaire hors du réservoir principal vers le sous-réservoir, et
dans lequel le réservoir principal est raccordé au sous-réservoir, avec l'ouverture positionnée plus haut qu'une surface inférieure du sous-réservoir.

3. Appareil de régulation de température selon la revendication 1, dans lequel le processeur est configuré pour commuter la pompe de refroidissement entre une première plage de sortie de puissance et une deuxième plage de sortie de puissance supérieure à la première plage de sortie de puissance, sur la base de la température du liquide circulant mesurée par le capteur de température, et pour entraîner la pompe de refroidissement, et
dans lequel, en réponse à la commutation, pendant l'entraînement de la pompe de refroidissement dans la première plage de sortie de puissance, le liquide circulant dans le circuit de refroidissement circule dans le circuit de refroidissement sans être alimenté vers le circuit de circulation par le biais du passage d'écoulement de raccordement et, pendant l'entraînement de la pompe de refroidissement dans la deuxième plage de sortie de puissance, le liquide circulant dans le circuit de refroidissement est alimenté vers le circuit de circulation par le biais du passage d'écoulement de raccordement tout en circulant dans le circuit de refroidissement.

4. Appareil de régulation de température selon la revendication 3, dans lequel le passage d'écoulement de raccordement bifurque à partir du deuxième passage d'écoulement de refroidissement du circuit de refroidissement et s'étend vers le haut.

5. Appareil de régulation de température selon la revendication 3 ou 4, dans lequel le capteur de température est un premier capteur de température (61) disposé dans le passage d'écoulement de décharge,
dans lequel le processeur compare une température cible prédéfinie avec la température du liquide circulant mesurée par le premier capteur de température,
dans lequel, si la température mesurée par le premier capteur de température est inférieure à la température cible, le processeur entraîne la pompe de refroidissement dans la première plage de sortie de puissance, et
dans lequel, si la température mesurée par le premier capteur de température est supérieure à la température cible, le processeur entraîne la pompe de refroidissement dans la deuxième plage de sortie de puissance.

6. Appareil de régulation de température selon la revendication 5, dans lequel la température mesurée par le premier capteur de température est inférieure à la température cible, le processeur régule en outre le moyen de chauffage et chauffe le liquide circulant dans le réservoir principal.

7. Appareil de régulation de température selon la revendication 5, dans lequel le passage d'écoulement de raccordement inclut un deuxième capteur de température (30) configuré pour mesurer la température du liquide circulant, et
dans lequel, pendant l'entraînement de la pompe de refroidissement dans la deuxième plage de sortie de puissance, le processeur calcule une différence de température entre la température cible et la température mesurée par le deuxième capteur de température, compare la différence de température avec une valeur de référence prédéfinie, et réduit la sortie de la pompe de refroidissement dans la deuxième plage de sortie de puissance lorsque la différence de température augmente par rapport à la valeur de référence.

8. Appareil de régulation de température selon la revendication 1, dans lequel l'échangeur de chaleur inclut un boîtier creux (32), au moins trois plaques de transfert de chaleur (34, 35) disposées parallèlement avec un espace entre elles à l'intérieur du boîtier, une série de premiers passages d'écoulement d'échangeur de chaleur (36) et une série de deuxièmes passages d'écoulement d'échangeur de chaleur (37) formés alternativement à partir des espaces entre les plaques de transfert de chaleur dans une direction d'agencement des plaques de transfert de chaleur, une entrée de liquide circulant (38a) disposée à une extrémité du premier passage d'écoulement d'échangeur de chaleur, l'entrée de liquide circulant étant raccordée au premier passage d'écoulement de refroidissement, une sortie de liquide circulant (38b) disposée à l'autre extrémité du premier passage d'écoulement d'échangeur de chaleur opposée à l'entrée de liquide circulant, la sortie de liquide circulant étant raccordée au deuxième passage d'écoulement de refroidissement, une entrée d'eau de dissipation de chaleur (38c) disposée à une extrémité du deuxième passage d'écoulement d'échangeur de chaleur, l'entrée d'eau de dissipation de chaleur étant utilisée pour conduire de l'eau de dissipation de chaleur vers le deuxième passage d'écoulement d'échangeur de chaleur, et une sortie d'eau de dissipation de chaleur (38d) disposée à l'autre extrémité du deuxième passage d'écoulement d'échangeur de chaleur opposée à l'entrée d'eau de dissipation de chaleur, la sortie d'eau de dissipation de chaleur étant utilisée pour décharger l'eau de dissipation de chaleur soumise à un échange de chaleur hors du deuxième passage d'écoulement d'échangeur de chaleur.
